(19) Europäisches Patentamt / European Patent Office / Office européen des brevets

(11) **EP 2 811 593 B1**

(12) **FASCICULE DE BREVET EUROPEEN**

(45) Date de publication et mention
de la délivrance du brevet:
**27.04.2016   Bulletin 2016/17**

(51) Int Cl.:
**H01S 5/026** *(2006.01)*    **H01S 5/10** *(2006.01)*
**H01S 5/12** *(2006.01)*    **H01S 5/062** *(2006.01)*
**H01S 5/0625** *(2006.01)*    **H01S 5/14** *(2006.01)*

(21) Numéro de dépôt: **13305766.1**

(22) Date de dépôt: **07.06.2013**

(54) **Dispositif d'émission laser accordable**

Vorrichtung zur Emission von abstimmbarem Laser

Tunable laser emitting device

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**10.12.2014   Bulletin 2014/50**

(73) Titulaires:
• **ALCATEL LUCENT
92100 Boulogne-Billancourt (FR)**
• **Commissariat à l'Énergie Atomique
et aux Énergies Alternatives
75015 Paris (FR)**

(72) Inventeurs:
• **Debregeas-Sillard, Hélène
Murray Hill, NJ 07974-0636 (US)**
• **Ben-Bakir, Badhise
38590 Brezins (FR)**
• **Duan, Guang-Hua
91767 Palaiseau (FR)**
• **Chimot, Nicolas
91460 Marcoussis (FR)**

(74) Mandataire: **Loyer & Abello
9, rue Anatole de la Forge
75017 Paris (FR)**

(56) Documents cités:
**US-A1- 2005 265 679**

• **STANKOVIC S ET AL: "Hybrid III V/Si Distributed-Feedback Laser Based on Adhesive Bonding", IEEE PHOTONICS TECHNOLOGY LETTERS, IEEE SERVICE CENTER, PISCATAWAY, NJ, US, vol. 24, no. 23, 1 décembre 2012 (2012-12-01), pages 2155-2158, XP011488545, ISSN: 1041-1135, DOI: 10.1109/LPT.2012.2223666**
• **DI LIANG ET AL: "Hybrid silicon evanescent approach to optical interconnects", APPLIED PHYSICS A; MATERIALS SCIENCE & PROCESSING, SPRINGER, BERLIN, DE, vol. 95, no. 4, 19 février 2009 (2009-02-19), pages 1045-1057, XP019710610, ISSN: 1432-0630**
• **LINJIE ZHOU ET AL: "Silicon-on-insulator electro-optically tunable waveguide-coupled microdisk resonators with selectively integrated p-i-n diodes", GROUP IV PHOTONICS, 2005. NUD IEEE INTERNATIONAL CONFERENCE ON ANTWERPEN, BELGIUM 21-23 SEPT., 2005, PISCATAWAY, NJ, USA,IEEE, 21 septembre 2005 (2005-09-21), pages 23-25, XP010841314, DOI: 10.1109/GROUP4.2005.1516390 ISBN: 978-0-7803-9070-6**
• **FEDELI J M ET AL: "Silicon photonics with InP on Si lasers for transceivers", OPTO-ELECTRONICS AND COMMUNICATIONS CONFERENCE (OECC), 2012 17TH, IEEE, 2 juillet 2012 (2012-07-02), pages 291-292, XP032223043, DOI: 10.1109/OECC.2012.6276484 ISBN: 978-1-4673-0976-9**
• **REED G T ET AL: "Silicon optical modulators", MATERIALS TODAY, ELSEVIER SCIENCE, KIDLINGTON, GB, vol. 8, no. 1, 1 janvier 2005 (2005-01-01) , pages 40-50, XP027848837, ISSN: 1369-7021 [extrait le 2005-01-01]**

## Description

### Domaine technique

L'invention se rapporte au domaine des dispositifs d'émission laser à semi-conducteurs accordables en longueur d'onde, notamment à une source laser utilisable dans les communications optiques, et en particulier dans un réseau optique à multiplexage de longueurs d'onde (ou WDM pour l'anglais Wavelength Division Multiplexing).

### Arrière-plan technologique

Des sources laser accordables connues sont notamment des lasers à réflecteur de Bragg (ou DBR pour l'anglais Distributed Bragg Reflector) dans lesquels le réglage de la longueur d'onde émise entraine une modification d'une condition de phase des modes longitudinaux de la cavité DBR. Il en résulte alors une accordabilité discontinue avec des sauts de modes. Une section de phase de la source laser permet d'aligner précisément un mode résonant de la cavité sur la longueur d'onde souhaitée. Il en résulte un dispositif relativement complexe à régler, dans lequel doivent être réglés simultanément un courant de contrôle de la section de gain, au moins un courant de contrôle du ou des réflecteurs distribués et un courant de contrôle de la section de phase.

Dans une autre solution appelée laser accordable à guides jumelés (ou TTG pour l'anglais Tunable Twin Guide-laser), une couche active en matériau InGaAsP se trouve au-dessus d'un réseau de Bragg passif en matériau InGaAsP. Des courants de contrôle indépendants sont injectés, d'une part dans la couche active pour régler le gain, et d'autre part dans le réseau de Bragg passif pour régler la longueur d'onde. Etant donné que le réseau de Bragg, dont l'indice effectif est modifiable par injection de courant, se trouve directement dans la zone d'amplification, les modes résonants du type DFB (distributed feedback en anglais) sont décalés par l'effet même de ce réglage sans qu'une section de phase ne soit nécessaire. L'accordabilté en longueur d'onde est continue sans aucun saut de modes.

### Résumé

Une idée à la base de l'invention est de fournir un dispositif d'émission laser accordable dont la plage de réglage soit relativement large et le contrôle relativement simple. Une autre idée à la base de l'invention est de fournir un procédé de fabrication fiable pour un tel dispositif d'émission laser.

Selon un mode de réalisation, l'invention fournit un dispositif d'émission laser accordable en longueur d'onde, comportant :

un premier guide d'onde comportant un moyen d'amplification optique pour produire une émission stimulée de lumière, le premier guide d'onde s'étendant selon une direction longitudinale du dispositif d'émission,

un deuxième guide d'onde réalisé en silicium sur dioxyde de silicium et disposé parallèlement au premier guide d'onde espacé du premier guide d'onde dans une direction verticale du dispositif d'émission de manière à permettre l'existence d'un mode optique hybride couplé à la fois au deuxième guide d'onde et au premier guide d'onde, le deuxième guide d'onde comportant un réflecteur distribué le long du deuxième guide d'onde, le deuxième guide d'onde comportant également des zones transversales dopées différemment de manière à former une jonction polaire orientée selon un direction transversale du dispositif d'émission,

des premières électrodes couplées au premier guide d'onde pour injecter un courant de pompage dans le moyen d'amplification optique, et

des deuxièmes électrodes couplées aux zones transversales dopées du deuxième guide d'onde pour modifier un indice effectif du deuxième guide d'onde vu par le mode optique hybride.

Les deux guides d'onde forment un système complet dans lequel existent des modes hybrides. Le mode optique hydride utilisé est de préférence surtout confiné dans le premier guide d'onde, mais il s'étend aussi vers le deuxième guide d'onde pour pouvoir expérimenter la variation périodique de l'indice de matériaux, créée par le réflecteur distribué, par exemple un réseau Bragg.

Grâce à ces caractéristiques, il est possible de contrôler ce mode hybride propagatif à la fois dans le premier guide d'onde muni du moyen d'amplification et dans le deuxième guide d'onde muni du réflecteur distribué, de sorte qu'un réglage du gain et de la longueur d'onde au moyen de deux contrôles électriques indépendants peut être obtenu sans qu'une section de phase ne soit nécessaire.

De plus, le deuxième guide d'onde réalisé en silicium sur dioxyde de silicium est muni d'un réflecteur distribué le long de la direction longitudinale et des zones transversales dopées différemment formant une jonction polaire orientée selon la direction transversale. Le choix du matériau en silicium donne accès à des techniques de fabrication fiables et relativement économiques pour cela. L'injection de courant ou l'application d'une tension électrique dans le deuxième guide d'onde peut ainsi être mise en oeuvre de manière relativement simple.

Selon des modes de réalisation, un tel dispositif d'émission laser peut comporter une ou plusieurs des caractéristiques suivantes.

Selon des modes de réalisation, le deuxième guide d'onde comporte une zone d'extraction pour rayonner la lumière du mode résonnant vers l'extérieur du dispositif d'émission laser, ou alors le deuxième guide d'onde est couplé directement à un autre composant optique intégré également sur le même substrat.

Selon un mode de réalisation, le premier guide d'onde est réalisé dans un matériau actif du groupe III-V. Notamment, le premier guide d'onde peut être fabriqué par les étapes de :

coller une vignette ou une plaque de matériaux du groupe III-V sur une plaque de Silicium sur isolant, dans laquelle le deuxième guide d'ondes a été gravé et implantée préalablement, et
réaliser le premier guide d'onde dans la vignette ou plaque de matériaux du groupe III-V, ce premier guide d'onde s'alignant avec le deuxième guide d'onde par lithographie optique.

Selon un autre mode de réalisation, le premier guide d'onde est réalisé dans un alliage de Germanium dopé. Un alliage de Germanium fortement dopé et contraint peut présenter un gain optique élevé. Dans ce cas, le premier guide d'onde peut être fabriqué par une méthode d'épitaxie directement sur le deuxième guide d'onde.

Selon un mode de réalisation, une couche de dioxyde de silicium de faible épaisseur est disposée entre le deuxième guide d'onde et le premier guide d'onde. Cette couche est optionnelle, elle peut faciliter le collage des composants. Selon un mode de réalisation, la couche de dioxyde de silicium de faible épaisseur présente une épaisseur inférieure à 100 nm.

Selon des modes de réalisation, la jonction polaire est de type P-N ou de type P-I-P-I-N.

Selon un mode de réalisation, la jonction polaire comporte une première zone transversale externe fortement dopée positivement et une deuxième zone transversale externe fortement dopée négativement, les deuxièmes électrodes étant disposées respectivement sur les deux zones transversales externes fortement dopées.

Selon un mode de réalisation, le réflecteur distribué présente un coefficient de couplage compris entre 10cm$^{-1}$ et 200 cm$^{-1}$.

Selon un mode de réalisation, le deuxième guide d'onde réalisé en silicium sur dioxyde de silicium présente une épaisseur comprise entre 400 nm et 600 nm.

Selon des modes de réalisation, le réflecteur distribué peut être périodique de période constante, ou présenter plusieurs sections périodiques de périodes différentes, ou encore présenter un pas variable le long de sa longueur. Le réseau distribué peut également comporter des épaisseurs de gravure différentes sur plusieurs sections.

Selon un mode de réalisation, le réflecteur distribué peut être de dimensionnalité 1 (ex : réseau de lignes) ou 2 (ex : réseau de trous ou de plots, carrés ou circulaires). Lorsque le réseau est de dimensionnalité 2, la maille peut être carré ou triangulaire. Les différents modes de réalisations cités pour le réseau 1D sont applicables aux réseaux 2D.

Selon un mode de réalisation, le deuxième guide d'onde comporte deux réseaux échantillonnés de période différente. Un réseau échantillonné comporte un certain nombre des zones périodiques correspondant à une période spatiale d'échantillonnage, qui est différente dans les deux réseaux échantillonnés. Dans chacune des zones correspondant à la période d'échantillonnage, le réseau échantillonné est gravé uniquement sur une portion de la longueur de la période, avec une deuxième période spatiale plus courte qui peut être égale dans les deux réseaux échantillonnés.

Selon un mode de réalisation, le dispositif comporte en outre un élément réflecteur optique agencé à une extrémité longitudinale du dispositif pour permettre que la lumière soit extraite uniquement par l'autre extrémité longitudinale du dispositif, et/ou d'assurer un fonctionnement bien monomode du dispositif. Selon un mode de réalisation, l'invention fournit aussi un terminal de communication optique comportant :

un dispositif d'émission laser accordable précité pour générer un signal porteur optique monochromatique,
un modulateur optique pour moduler un signal de données sur le signal porteur, un capteur de température, et
un module de stabilisation de longueur d'onde couplé aux deuxièmes électrodes du dispositif d'émission laser pour appliquer un signal électrique de contrôle dans le deuxième guide d'onde, par exemple un courant ou une tension, le module de stabilisation de longueur d'onde étant apte à produire le signal de contrôle en fonction d'un signal de mesure du capteur de température pour compenser une dérive thermique de la longueur d'onde du signal porteur optique.

Grâce à ces caractéristiques, le terminal de communication optique ne nécessite pas un environnement climatisé ou refroidi, étant donné que la longueur d'onde émise peut être stabilisée de manière simple, sans saut de mode, en fonction de la mesure de température lorsque la température ambiante varie. Il en résulte la possibilité d'offrir un terminal de communication optique adapté à un réseau WDM, par exemple à un réseau d'accès passif, très avantageux en termes de consommation d'énergie, de coût de fabrication et de simplicité d'utilisation.

Selon un mode de réalisation, l'invention fournit aussi un procédé de fabrication pour fabriquer un dispositif d'émission laser accordable en longueur d'onde, le procédé comportant :

réaliser un deuxième composant optique monolithique comprenant un deuxième guide d'onde réalisé en silicium sur dioxyde de silicium et s'étendant selon une direction longitudinale du deuxième composant optique monolithique, le deuxième guide d'onde comportant un réflecteur distribué le long du deuxième guide d'onde, le deuxième guide d'onde comportant des zones transversales dopées différemment de manière à former une jonction polaire orientée selon une direction transversale du deuxième composant optique, le deuxième composant optique monolithique comprenant une couche superficielle de dioxyde de silicium de faible épaisseur recouvrant le deuxième guide d'onde au niveau d'une surface supérieure du deuxième composant optique,
coller un premier composant optique monolithique en matériaux du groupe III-V sur la surface supérieure du deuxième composant optique, le premier composant optique monolithique comportant une couche guidante amplificatrice de la lumière, réaliser un premier guide d'onde dans le premier composant optique monolithique, le premier guide d'onde étant réalisé par lithographie de manière alignée avec le deuxième guide d'onde,
former sur le premier composant optique monolithique des premières électrodes pour contrôler le gain d'amplification optique, et
former sur le deuxième composant optique monolithique des deuxièmes électrodes couplées aux zones transversales dopées du deuxième guide d'onde pour modifier un indice effectif du deuxième guide d'onde.

Selon un mode de réalisation, le collage du premier composant optique monolithique sur la surface supérieure du deuxième composant optique est réalisé par mise sous pression, de préférence à l'aide d'un adhésif en polymère.

Selon un mode de réalisation, le premier composant optique est une vignette ou une plaque de matériaux du groupe III-V qui comporte une couche guidante amplificatrice de la lumière et le deuxième composant optique est une plaque de Silicium sur isolant dans laquelle le deuxième guide a été gravé préalablement.

Selon des modes de réalisation, d'autres étapes peuvent aussi être réalisées après le collage, par exemple encapsulation du premier guide d'onde, métallisation pour former des électrodes pour permettre de contrôler le gain d'amplification, et élimination locale des matières III-V collées pour ensuite déposer des couches métalliques formant les deuxièmes électrodes sur le deuxième guide d'onde.

**Brève description des figures**

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.

• La figure 1 est une vue en coupe transversale d'une source laser à contre-réaction distribuée (ou DFB pour l'anglais Distributed FeedBack.) selon un mode de réalisation, coupé selon la ligne I-I de la figure 3.

• La figure 2 est une vue en coupe du dispositif de la figure 1 selon la ligne II-II dans le figure 3.

• La figure 3 est une vue en coupe longitudinale du dispositif de la figure 1 selon la ligne III-III dans le figure 1.

• Les figures 4 à 10 représentent partiellement, à différentes étapes successives de la fabrication, plusieurs zones d'une source laser à contre-réaction distribuée selon un autre mode de réalisation.

• La figure 11 est un graphique représentant l'évolution de différentes caractéristiques de la source laser de la figure 1 en fonction de la largeur du guide d'onde en silicium.

• La figure 12 est une représentation schématique fonctionnelle d'un terminal de communication optique selon un mode de réalisation.

• La figure 13 est une représentation schématique en coupe longitudinale d'un guide d'onde muni de deux réseaux échantillonnés ayant des périodes différentes.

**Description détaillée de modes de réalisation**

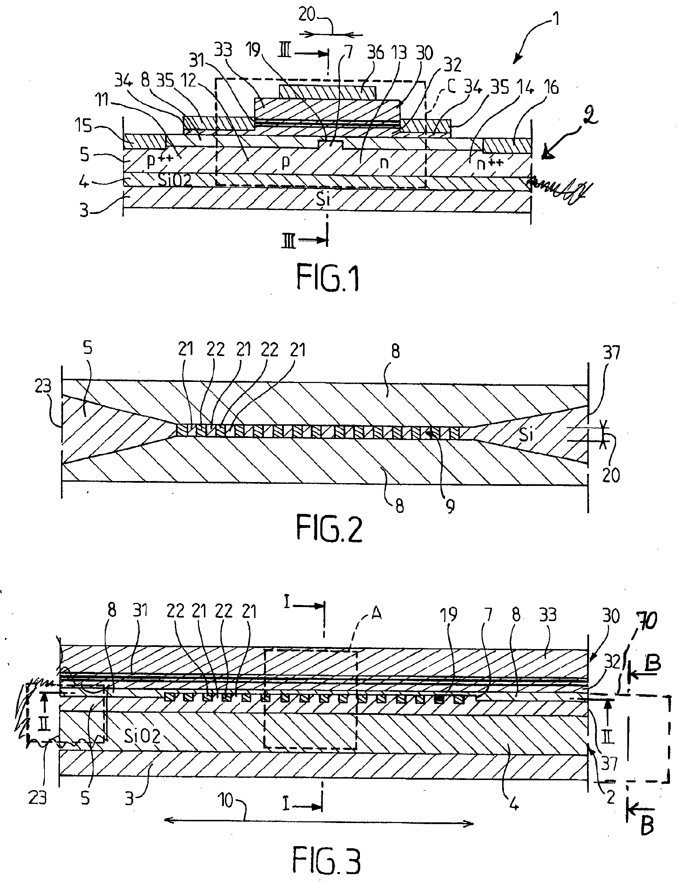

En référence aux figures 1 à 3, on décrit maintenant une source laser à semi-conducteurs 1 représentée dans différentes vues en coupe. En partant du bas des figures, la source laser comporte un guide optique en semi-conducteur 2, réalisé en silicium sur isolant (ou SOI pour l'anglais Silicon On Insulator) et constitué d'une couche de base en silicium 3, une couche de base 4 en dioxyde de silicium SiO2, autrement dit en silice, et une couche guidante en silicium 5, et éventuellement une couche en silice 8. Les interfaces entre couches sont planes et parallèles. On appelle direction verticale la direction dans laquelle ces couches se succèdent, étant entendu que cette appellation conventionnelle ne correspond pas nécessairement à la direction du champ de gravitation terrestre.

Dans une portion centrale 10 de la longueur du laser 1, la couche guidante en silicium 5 comporte plusieurs zones successives dans la direction transversale qui sont dopées différemment pour former une jonction P-N, à savoir de la gauche vers la droite de la figure 1, une bande longitudinale 11 fortement dopée positivement, une bande longitudinale 12 dopée positivement, une bande longitudinale 13 dopée négativement et une bande longitudinale 14 fortement dopée négativement. Sur une portion d'extrémité latérale, la bande longitudinale 11 porte une métallisation 15 déposée sur la couche guidante en silicium 5. De même, sur une portion d'extrémité latérale, la bande longitudinale 14 porte une métallisation 16 déposée sur la couche guidante en silicium 5. Les métallisations 15 et 16 servent d'électrode pour appliquer un signal électrique à la jonction P-N, ce qui permet de modifier l'indice optique de la couche guidante en silicium 5, et donc du réseau de diffraction qui est gravé en son centre.

Dans une portion centrale 20 de la largeur du laser 1, la couche guidante en silicium 5 comporte une nervure étroite 7 en saillie vers le haut, de faible largeur par rapport à la couche guidante 5 dans son ensemble. Un réseau de diffraction 9 est gravé dans la nervure 7 le long de la direction longitudinale de la couche guidante 5. Le réseau de diffraction 9 comporte une alternance périodique de zones en silicium 21 et de zones en silice 22. Le réseau de diffraction 9 constitue un réflecteur distribué qui réalise une cavité optique du type DFB.

Un revêtement totalement réflecteur 23 recouvre une surface d'extrémité longitudinale du laser 1. L'autre extrémité 37 porte un revêtement semi-réfléchissant et constitue la sortie du faisceau laser.

Dans une variante de réalisation esquissée en traits interrompus sur la figure 3, le laser 1 est couplé au niveau de l'extrémité 37 avec un autre composant optique 70 intégré sur le même substrat que le laser 1, par exemple un modulateur optique, un récepteur cohérent ou tout autre composant optique utilisable avec une source laser. Dans ce cas, le guide d'onde 2 se prolonge dans le composant optique 70, de sorte que le laser 1 n'a pas directement de sortie vers l'extérieur. Le revêtement semi-réfléchissant sur l'extrémité 37 est alors supprimé.

Entre les métallisations 15 et 16, la couche guidante en silicium 5 est recouverte sur toute sa largeur, y compris la nervure étroite 7, d'une couche de silice 8. La couche de silice 8 comporte une portion de faible épaisseur 19 au-dessus du réseau de diffraction 9. Ainsi, la surface supérieure de la couche de silice 8 est plane et parallèle à l'interface entre les couches 4 et 5.

Sur la surface supérieure de la couche de silice 8 est disposé un deuxième guide optique en semi-conducteurs 30, réalisé par exemple en matériaux du groupe III-V, qui comporte une structure multicouche ayant une couche guidante active 31 disposée entre deux couches passives 32 et 33, par exemple une pile InP/InGaAsP/InP.

Le guide d'onde 30 s'étend longitudinalement sur toute la longueur du guide d'onde 2, ou du moins au-delà de la portion centrale 10 du guide d'onde 2. Dans la direction transversale du laser 1, le guide d'onde 30 est plus large que le guide d'onde 2.

La couche passive inférieure 32 du guide d'onde 30 présente deux ailes latérales 34 s'élargissant au-delà des bords d'extrémités latérales de la couche guidante active 31 et de la couche passive supérieure 33. Les deux ailes 34 sont recouvertes d'une métallisation 35 tandis que la surface supérieure de la couche 33 est recouverte d'une métallisation 36. Les métallisations 35 et 36 servent d'électrode pour appliquer un signal électrique de pompage au matériau actif pour créer l'inversion de population.

Le dimensionnement des différentes parties du laser 1 est effectué de manière qu'il existe un couplage optique entre la couche guidante 5 et la couche guidante active 31, qui engendre un mode optique résonant hybride dont l'énergie est distribuée à la fois dans la couche guidante 5 et dans la couche guidante active 31, ce qui permet de bénéficier à la fois de l'amplification produite dans la couche guidante active 31 et de la sélection de longueur d'onde produite par le réseau de diffraction 9 dans la couche guidante 5.

Le coefficient de couplage du réseau de diffraction 9 est de préférence dans la plage de 10 à 200 cm$^{-1}$ de manière à obtenir un rendement élevé du laser 1 dans un fonctionnement monomode. Dans un mode de réalisation, la couche guidante 5 présente une épaisseur de 440 nm au niveau de la nervure 7 et la hauteur saillante de la nervure est de 220 nm, le réseau de diffraction 9 étant gravé sur une profondeur de 50 nm dans la hauteur de la nervure 7.

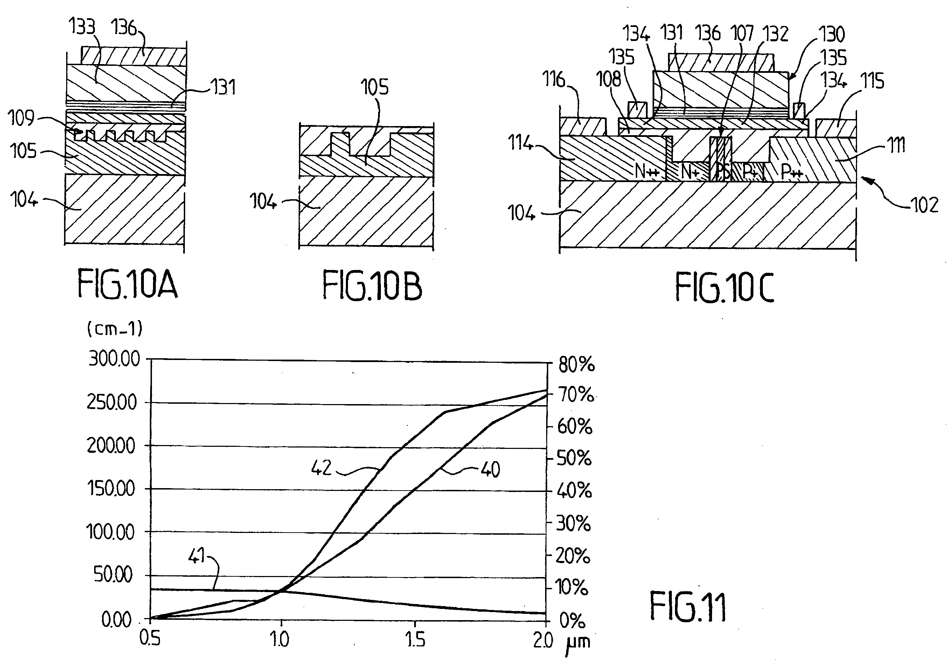

La figure 11 représente, pour ce mode de réalisation du réseau 9, le coefficient de couplage du réseau sur la courbe 40, le facteur de confinement du mode optique dans la couche 31 en matériau actif sur la courbe 41, et le facteur de confinement du mode optique dans la couche 5 en silicium sur la courbe 42, en fonction de la largeur de la nervure 7 exprimée en $\mu$m. Ainsi, à titre d'illustration, un coefficient de couplage compris entre 20 et 100 cm$^{-1}$, un facteur de confinement dans le milieu à gain compris entre 6 et 8% et un facteur de confinement dans le silicium compris entre 2 et 40 % sont obtenus pour une nervure de largeur comprise entre 0,8 et 1,2 $\mu$m.

De préférence, le facteur de confinement dans le silicium est supérieur à 10% pour que la variation d'indice optique dans la couche 5 ait un effet substantiel sur le mode optique hybride. Pour un facteur de confinement dans le silicium situé autour de 30%, étant donné que la variation d'indice du silicium maximale qu'il est possible d'obtenir par injection de courant dans la jonction P-N est de l'ordre de $5.10^{-2}$, la largeur de la plage d'accord de longueur d'onde peut être estimée à environ 10 nm.

La variation de l'indice effectif $n_{eff}$ vu par le mode optique hybride est obtenue en conséquence de l'injection de courant ou de l'application d'une tension dans le silicium, étant donné que l'indice effectif du réseau de diffraction est une moyenne pondérée des indices respectifs des matériaux silicium, dioxyde de silicium et matériau du groupe III-V, où le coefficient de pondération est le facteur de confinement de l'intensité de champ électromagnétique du mode hybride dans les différentes couches.

La longueur d'onde de Bragg vue par le mode hybride est donnée par :

$$\lambda = 2 \, n_{eff.} \, \Lambda$$

Où A désigne le pas du réseau de diffraction 9.

En variante, la variation d'indice peut être provoquée par effet thermique, injection de porteurs ou déplétion de porteurs.

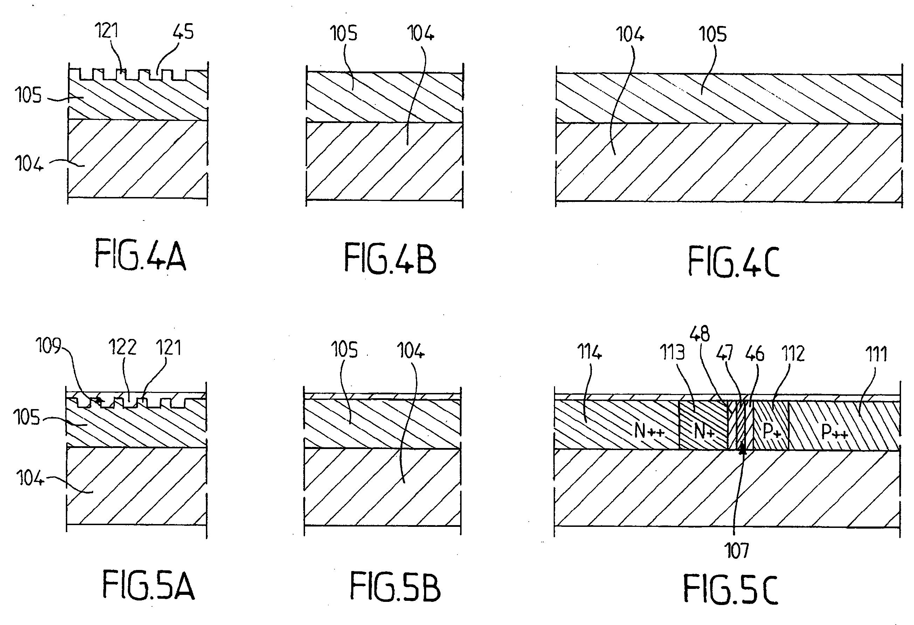

En référence aux figures 4 à 10, on va décrire maintenant un autre mode de réalisation d'une source laser accordable et son procédé de fabrication. Les éléments analogues ou identiques à ceux des figures 1 à 3 portent le même chiffre de référence augmenté de 100. Dans ce mode de réalisation, la jonction P-N susmentionnée est remplacée par une jonction P-I-P-I-N.

Sur la figures 4 à 10, trois vues A, B et C sont représentées à chaque étape du procédé de fabrication. La vue A correspond à la zone A de la figure 3, à savoir le milieu du dispositif vu en coupe longitudinale. La vue B correspond à la coupe B-B de la figure 3, à savoir un composant optique intégré sur le même substrat que le laser et vu en coupe transversale. La vue C correspond à la zone C de la figure 1, à savoir le milieu du dispositif vu en coupe transversale.

Sur la figure 4, le procédé part d'une galette de Silicium sur isolant (silicone) dont l'épaisseur est de préférence supérieure à 400 nm. Le dessus de la couche de silicium 105 est gravé avec une succession de dents 121 et de creux 45 pour former le réseau de Bragg 109 qui définira les longueurs d'onde résonnantes du laser.

Sur la figure 5, des zones transversales adjacentes 111, 112, 46, 47, 48, 113 et 114 de la couche de silicium 105 sont dopées pour former la jonction P-I-P-I-N, à savoir de la droite vers la gauche de la figure 5C, une bande longitudinale 111 fortement dopée positivement, une bande longitudinale 112 dopée positivement, une zone de jonction centrale 50 comportant une étroite bande 47 dopée positivement entre deux bandes de silicium non dopées 46 et 48, une bande longitudinale 113 dopée négativement et une bande longitudinale 114 fortement dopée négativement. Le dopage positif est effectué par exemple par implantation d'atomes de bore, et le dopage négatif par implantation d'atomes de phosphore. Un dépôt de silicone est effectué pour combler les creux 45.

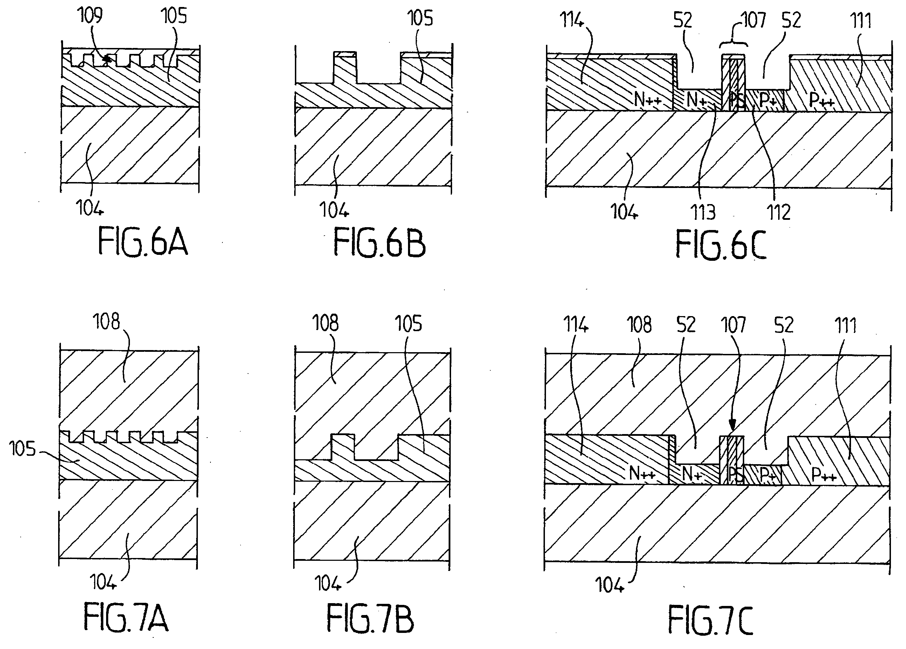

Sur la figure 6, la couche guidante 105 de silicium est partiellement éliminée de chaque côté de la zone centrale 107 pour former des canaux 52 destinés à délimiter des guides d'onde et laisser la zone centrale 107 faire saillie sous la forme d'une nervure.

Sur la figure 7, une épaisse couche de dioxyde de silicium 108, préférablement supérieure à 0,5μm, est déposée sur l'ensemble de la couche 105 et remplit ainsi les canaux 52.

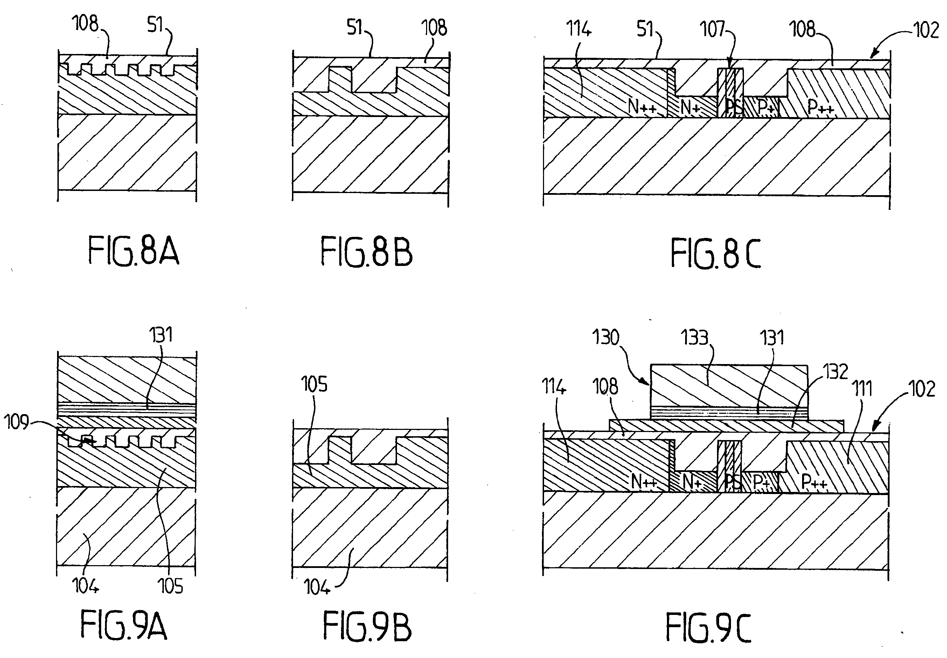

Sur la figure 8, l'épaisse couche de dioxyde de silicium 108 est éliminée et polie de manière chimique et mécanique jusqu'à laisser subsister une fine couche 108 de dioxyde de silicium avec un état de surface très lisse sur la surface supérieure 51. L'épaisseur restante est de préférence comprise entre 30 nm et 100 nm au-dessus de la nervure centrale 107. La couche de dioxyde de silicium 108 peut également être complètement supprimée sans conséquence significative pour le fonctionnement du dispositif.

Sur la figure 9, un deuxième composant optique monolithique 130 fabriqué séparément en matériau du groupe III-V comporte la couche guidante active 131 disposée entre deux couches passives 132 et 133. Le composant 130 est assemblé par collage sur la surface supérieure 51 du composant 102 précédemment obtenu. Le collage du composant 130 sur le composant 102 est effectué par exemple à température ambiante avec mise sous pression ou à l'aide d'un adhésif en polymère DVS-BCB. Au stade du collage, le composant optique 130 est une vignette ou une plaque de matériaux du groupe III-V. On procède ensuite à une étape de photolithographie et de gravure dans la plaque de matériaux du groupe III-V pour réaliser un guide d'onde aligné avec le guide d'onde formé dans les canaux 52 du composant 102.

Enfin, sur la figure 10, une métallisation 136 est déposée sur le dessus du composant 130 pour former l'anode et des métallisations 135 sont déposées sur les deux ailes 134 pour former la cathode du composant optique 130.

De même une métallisation 115 est déposée sur la zone dopée 111 et une métallisation 116 sur la zone dopée 114 de la couche de silicium 105, après élimination de la couche 108 à cet endroit, pour former l'anode et la cathode du composant optique 102.

Ainsi, en fonctionnement, un premier signal de commande électrique appliqué entre l'anode 136 et la cathode 135 du composant optique 130 permet de contrôler la puissance optique émise, tandis qu'un deuxième signal de commande électrique appliqué entre l'anode 115 et la cathode 116 du composant optique 102 permet de contrôler indépendamment la longueur d'onde optique émise dans un fonctionnement monomode.

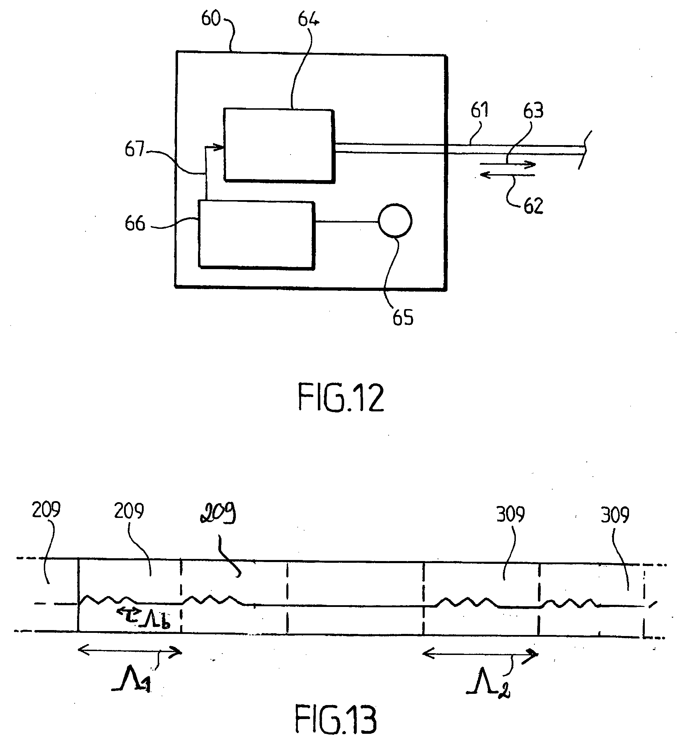

Dans des modes de réalisation, le réseau de diffraction 9 réalisé dans le guide d'onde 2 peut présenter des structures plus complexes. Dans l'exemple illustré sur la figure 13, le réseau de diffraction 9 est réalisé sous la forme de deux réseaux échantillonnés de périodes d'échantillonnage différentes $\Lambda_1$ et $\Lambda_2$. Un réseau échantillonné comporte un certain nombre de zones périodiques 209 et 309 correspondant à la période d'échantillonnage respective. Dans les zones périodiques 209 et 309, chaque réseau échantillonné est gravé uniquement sur une portion de la longueur de la période, avec une période spatiale plus courte, dite longueur de Bragg $\Lambda_b$ qui peut être la même dans les deux réseaux échantillonnés.

Les sources laser décrites ci-dessus peuvent être employées dans divers appareils de communication optique. La simplicité du contrôle de ces sources permet de les déployer notamment dans des appareils destinés au grand public à un coût modéré. En référence à la figure 12, on a représenté schématiquement un terminal de communication 60 d'un réseau optique passif, qui peut être utilisé par exemple dans une application résidentielle. Le terminal 60 est relié à une fibre optique 61 sur laquelle il reçoit un signal descendant 62 depuis un central de communication et il émet un signal montant 63 à une autre longueur d'onde en direction du central de communication (non représenté).

Pour produire le signal montant 63, le terminal 60 comporte une source laser accordable 64, réalisée par exemple comme décrit plus haut, et d'autres composants non représentés tels que modulateur/démodulateur, carte électronique, interfaces électriques etc. Pour stabiliser au cours du temps la longueur d'onde d'émission de la source laser 64, un capteur de température 65 et une unité de commande 66 sont prévus. L'unité de commande 66 exploite la mesure de température pour corriger au cours du temps le signal de contrôle 67 appliqué entre l'anode et la cathode du guide optique fabriqué en silicium sur isolant, de manière à compenser la dérive thermique de la longueur d'onde émise.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

Certains des éléments représentés, notamment les unités de commande, peuvent être réalisés sous différentes formes, de manière unitaire ou distribuée, au moyen de composants matériels et/ou logiciels. Des composants matériels utilisables sont les circuits intégrés spécifiques ASIC, les réseaux logiques programmables FPGA ou les microprocesseurs. Des composants logiciels peuvent être écrits dans différents langages de programmation, par exemple C, C++, Java ou VHDL. Cette liste n'est pas exhaustive.

L'usage du verbe « comporter », « comprendre » ou « inclure » et de ses formes conjuguées n'exclut pas la présence d'autres éléments ou d'autres étapes que ceux énoncés dans une revendication. L'usage de l'article indéfini « un » ou « une » pour un élément ou une étape n'exclut pas, sauf mention contraire, la présence d'une pluralité de tels éléments ou étapes.

Dans les revendications, tout signe de référence entre parenthèses ne saurait être interprété comme une limitation de la revendication.

**Revendications**

1. Dispositif d'émission laser (1) accordable en longueur d'onde, comportant :

un premier guide d'onde (31, 131) comportant un moyen d'amplification optique pour produire une émission stimulée de lumière, le premier guide d'onde s'étendant selon une direction longitudinale du dispositif d'émission,
un deuxième guide d'onde (5, 105) réalisé en silicium sur dioxyde de silicium et disposé parallèlement au premier guide d'onde espacé du premier guide d'onde dans une direction verticale du dispositif d'émission de manière à permettre l'existence d'un mode optique hybride couplé à la fois au deuxième guide d'onde et au premier guide d'onde, le deuxième guide d'onde comportant un réflecteur distribué (9, 109) le long du deuxième guide d'onde au droit du premier guide d'onde, le deuxième guide d'onde comportant des zones transversales (11, 12, 13, 14 ; 111, 112, 113, 114, 46, 47, 48) dopées différemment de manière à former une jonction polaire orientée selon un direction transversale du dispositif d'émission,
des premières électrodes (35, 36 ; 135, 136) couplées au premier guide d'onde pour injecter un courant de pompage dans le moyen d'amplification optique, et des deuxièmes électrodes (15, 16 ; 115, 116) couplées aux zones transversales dopées du deuxième guide d'onde pour modifier un indice effectif du deuxième guide d'onde vu par le mode optique hybride,.

2. Dispositif selon la revendication 1, dans lequel le premier guide d'onde (31, 32, 33) est réalisé dans un matériau actif du groupe III-V.

3. Dispositif selon la revendication 1 ou 2, dans lequel une couche de dioxyde de silicium (8, 108) de faible épaisseur est disposée entre le deuxième guide d'onde et le premier guide d'onde, la couche de dioxyde de silicium (8, 108) de faible épaisseur présentant une épaisseur inférieure à 100 nm.

4. Dispositif selon l'une des revendications 1 à 3, dans lequel la jonction polaire (11, 12, 13, 14) est de type P-N.

5. Dispositif selon l'une des revendications 1 à 3, dans lequel la jonction polaire (111, 112, 113, 114, 46, 47, 48) est de type P-I-P-I-N.

6. Dispositif selon l'une des revendications 1 à 5, dans lequel la jonction polaire comporte une première zone transversale externe (11, 111) fortement dopée positivement et une deuxième zone transversale (14, 114) externe fortement dopée négativement, les deuxièmes électrodes étant disposées respectivement sur les deux zones transversales externes fortement dopées.

7. Dispositif selon l'une des revendications 1 à 6, dans lequel le réflecteur distribué (9, 109) présente un coefficient de couplage compris entre 10 cm$^{-1}$ et 200

cm$^{-1}$.

8. Dispositif selon l'une des revendications 1 à 7, dans lequel le deuxième guide d'onde (5, 105) réalisé en silicium sur dioxyde de silicium présente une épaisseur comprise entre 400 nm et 600 nm.

9. Dispositif selon l'une des revendications 1 à 8, dans lequel le réflecteur distribué (9, 109) est périodique.

10. Dispositif selon l'une des revendications 1 à 9, dans lequel le deuxième guide d'onde (5, 105) comporte deux réseaux échantillonnés, chaque réseau échantillonné comportant une pluralité de zones périodiques (209, 309) correspondant à une période spatiale d'échantillonnage ($\Lambda_1$, $\Lambda_2$), qui est différente dans les deux réseaux échantillonnés et, dans chacune des zones périodiques (209, 309), le réseau échantillonné étant gravé uniquement sur une portion de la longueur de la période d'échantillonnage ($\Lambda_1$, $\Lambda_2$), avec une période spatiale ($\Lambda_b$) plus courte que la période d'échantillonnage.

11. Dispositif selon l'une des revendications 1 à 10, comportant en outre un élément réflecteur optique (23) agencé à une extrémité longitudinale du dispositif.

12. Dispositif selon l'une des revendications 1 à 11, dans lequel le deuxième guide d'onde comporte une zone d'extraction (37) pour rayonner la lumière du mode optique hybride vers l'extérieur du dispositif d'émission laser.

13. Terminal de communication optique (60) comportant :

un dispositif d'émission laser accordable (64) selon l'une des revendications 1 à 11 pour générer un signal porteur optique monochromatique,
un modulateur optique pour moduler un signal de données sur le signal porteur, un capteur de température (65), et
un module de stabilisation de longueur d'onde (66) couplé aux deuxièmes électrodes du dispositif d'émission laser (64) pour appliquer un signal électrique de contrôle dans le deuxième guide d'onde, le module de stabilisation de longueur d'onde étant apte à produire le signal de contrôle en fonction d'un signal de mesure du capteur de température pour compenser une dérive thermique de la longueur d'onde du signal porteur optique.

14. Procédé de fabrication pour fabriquer un dispositif d'émission laser accordable en longueur d'onde, le procédé comportant :

réaliser un deuxième composant optique monolithique (20, 102) comprenant un deuxième guide d'onde (5, 105) réalisé en silicium sur dioxyde de silicium et s'étendant selon une direction longitudinale du deuxième composant optique monolithique, le deuxième guide d'onde comportant un réflecteur distribué (9, 109) le long du deuxième guide d'onde, le deuxième guide d'onde comportant des zones transversales (11, 12, 13, 14 ; 111, 112, 113, 114, 46, 47, 48) dopées différemment de manière à former une jonction polaire orientée selon une direction transversale du deuxième composant optique, le deuxième composant optique monolithique comprenant une couche superficielle (8, 108) de dioxyde de silicium de faible épaisseur recouvrant le deuxième guide d'onde au niveau d'une surface supérieure du deuxième composant optique,
coller un premier composant optique monolithique (30, 130) en matériaux du groupe III-V sur la surface supérieure (51) du deuxième composant optique, le premier composant optique monolithique comportant une couche guidante (31, 131) amplificatrice de la lumière,
réaliser un premier guide d'onde dans le premier composant optique monolithique, le premier guide d'onde étant réalisé de manière alignée par lithographie avec le deuxième guide d'onde,
former sur le premier composant optique monolithique des premières électrodes (35, 36 ; 135, 136) pour contrôler le gain d'amplification optique, et
former sur le deuxième composant optique monolithique des deuxièmes électrodes (15, 16 ; 115, 116) couplées aux zones transversales dopées du deuxième guide d'onde pour modifier un indice effectif du deuxième guide d'onde.

15. Procédé selon la revendication 14, dans lequel le collage du premier composant optique monolithique (30, 130) sur la surface supérieure du deuxième composant optique (2, 102) est réalisé par mise sous pression, de préférence à l'aide d'un adhésif en polymère.

**Patentansprüche**

1. Vorrichtung zur Laseremission (1) abstimmbarer Wellenlängen umfassend:

einen ersten Wellenleiter (31, 131) umfassend ein Mittel zur optischen Kopplung, um eine stimulierte Lichtemission zu produzieren, wobei sich der erste Wellenleiter in einer Längsrichtung zur Emissionsvorrichtung erstreckt,
einen zweiten Wellenleiter (5, 105) erzeugt aus Silizium auf Siliziumdioxid und parallel zum ersten Wellenleiter angeordnet, beabstandet vom ersten Wellenleiter in einer vertikalen Richtung zur Emissionsvorrichtung, so dass ein optischer Hybrid-Modus verbunden sowohl mit dem zweiten und dem ersten Wellenleiter entsteht, wobei der zweite Wellenleiter einen verteilten Reflektor (9, 109) entlang des zweiten Wellenleiters unter dem ersten Wellenleiter umfasst, wobei der zweite Wellenleiter transversale Bereiche (11, 12, 13, 14; 111, 112, 113, 114, 46, 47, 48) umfasst, welche unterschiedlich schwingen, so dass sie eine polare Verbindung, transversal zur Emissionsvorrichtung ausgerichtet, bilden, erste Elektroden (35, 36; 135, 136) verbunden mit dem ersten Wellenleiter, um einen Pumpstrom in das Mittel zur optischen Kopplung zu injizieren, und zweite Elektroden (15, 16; 115, 116) verbunden mit den schwingenden transversalen Bereichen des zweiten Wellenleiters, um eine effektive Kennzahl des zweiten Wellenleiters mittels eines optischen Hybridmodus zu ändern.

2. Vorrichtung gemäß Anspruch 1, wobei der erste Wellenleiter (31, 32, 33) aus einem aktiven Material der Gruppe III-V realisiert ist.

3. Vorrichtung gemäß Anspruch 1 oder 2, wobei eine Siliziumdioxidschicht (8, 108) mit geringer Stärke zwischen dem zweiten Wellenleiter und dem ersten Wellenleiter angeordnet ist, wobei die Siliziumdioxidschicht (8, 108) mit geringer Stärke eine Stärke unter 100 nm aufweist.

4. Vorrichtung gemäß einem der Ansprüche 1 bis 3, wobei die polare Verbindung (11, 12, 13, 14) vom Typ P-N ist.

5. Vorrichtung gemäß einem der Ansprüche 1 bis 3, wobei die polare Verbindung (111, 112, 113, 114, 46, 47, 48) vom Typ P-I-P-I-N ist.

6. Vorrichtung gemäß einem der Ansprüche 1 bis 5, wobei die polare Verbindung einen ersten externen transversalen Bereich (11, 111), stark positiv schwingend, und einen zweiten externen transversalen Bereich (14, 114), stark negativ schwingend, umfasst, wobei die zweiten Elektroden jeweils auf den beiden stark schwingenden externen transversalen Bereichen angeordnet sind.

7. Vorrichtung gemäß einem der Ansprüche 1 bis 6, wobei der verteilte Reflektor (9, 109) einen Kopplungskoeffizienten zwischen 10 cm$^{-1}$ und 200 cm$^{-1}$ aufweist.

8. Vorrichtung gemäß einem der Ansprüche 1 bis 7, wobei der zweite Wellenleiter (5, 105) erzeugt aus Silizium auf Siliziumdioxid eine Stärke zwischen 400 nm und 600 nm aufweist.

9. Vorrichtung gemäß einem der Ansprüche 1 bis 8, wobei der verteilte Reflektor (9, 109) periodisch ist.

10. Vorrichtung gemäß einem der Ansprüche 1 bis 9, wobei der zweite Wellenleiter (5, 105) zwei gesampelte Gitter umfasst, wobei jedes gesampelte Gitter eine Vielzahl von periodischen Bereichen (209, 309) entsprechend einer räumlichen Sampel-Periode ($\Lambda_1$, $\Lambda_2$) umfasst, welche unterschiedlich in den zwei gesampelten Gittern ist, und, wobei in jedem der periodischen Bereiche (209, 309) das gesampelten Gitter nur auf einem Abschnitt der Länge der Sampel-Periode ($\Lambda_1$, $\Lambda_2$) eingraviert ist mit einer räumlichen Periode ($\Lambda_b$), welche kürzer als die Sampel-Periode ist.

11. Vorrichtung gemäß einem der Ansprüche 1 bis 10, umfassend des Weiteren ein optisches Reflektorelement (23), verbunden mit einem Längsende der Vorrichtung.

12. Vorrichtung gemäß einem der Ansprüche 1 bis 11, wobei der zweite Wellenleiter einen Extraktionsbereich (37) umfasst, um das Licht des optischen Hybrid-Modus nach außerhalb der Laseremissionsvorrichtung auszustrahlen.

13. Endgerät zur optischen Übertragung (60) umfassend:

    eine abstimmbare Vorrichtung zur Laseremission (64) gemäß einem der Ansprüche 1 bis 11, um ein monochromatisches optisches Trägersignal zu erzeugen, einen optischen Modulator zum Modulieren eine Datensignals auf dem Trägersignal, einen Temperaturfühler (65), und ein Modul zur Stabilisierung der Wellenlänge (66), gekoppelt mit den zweiten Elektroden der Laseremissionsvorrichtung (64), um ein elektrisches Kontrollsignal in dem zweiten Wellenleiter anzubringen, wobei das Modul zur Stabilisation der Wellenlänge in der Lage ist, ein Kontrollsignal in Abhängigkeit eines Messsignals des Temperaturfühlers hervorzubringen, um eine thermische Abweichung der Wellenlänge des optischen Trägersignals zu kompensieren.

14. Herstellungsverfahren zur Herstellung einer Vorrichtung zur Laseremission abstimmbarer Wellenlängen, das Verfahren umfassend:

    Verwirklichen einer zweiten monolithischen optischen Komponente (20, 102) umfassend einen zweiten Wellenleiter (5, 105) erzeugt aus Silizium auf Siliziumdioxid, der sich entsprechend einer Längsrichtung der zweiten monolithischen optischen Komponente erstreckt, wobei der zweite Wellenleiter einen verteilten Reflektor (9, 109) entlang der zweiten Wellenlänge umfasst, wobei die zweite Wellenlänge transversale Bereiche (11, 12, 13, 14, ;111, 112, 113, 114, 46, 47, 48), welche unterschiedlich schwingen, so dass eine polare Verbindung entsprechend der transversalen Richtung der zweiten optischen Komponente entsteht, umfasst, wobei die zweite monolithische optische Komponente eine Oberflächenschicht (8, 108) aus Siliziumdioxid mit einer geringen Stärke umfasst, welche den zweiten Wellenleiter im Bereich der Oberseite der zweiten optischen Komponente abdeckt, Verkleben einer ersten monolithischen optischen Komponente (30, 130) aus Material der Gruppe III-V mit der Oberseite (51) der zweiten optischen Komponente, wobei die erste monolithische optische Komponente eine lichtverstärkende Leiterschicht (31, 131) umfasst, Verwirklichen eines ersten Wellenleiters in der ersten monolithischen optischen Komponente, wobei der erste Wellenleiter in aneinandergereihter Form durch Lithographie mit dem zweiten Wellenleiter verwirklicht wird, Bildung erster Elektroden (35, 36; 135, 136) auf der ersten monolithischen optischen Komponente, um den Zugewinn an optischer Verstärkung zu kontrollieren, und Bildung zweiter Elektroden (15, 16; 115, 116) auf der zweiten monolithischen optischen Komponente, wobei die zweiten Elektroden mit den schwingenden transversalen Bereichen des zweiten Wellenleiters verbunden sind, um eine effektive Kennzahl des zweiten Wellenleiters zu modifizieren.

**15.** Verfahren gemäß Anspruch 14, wobei das Verkleben der ersten monolithischen optischen Komponente (30, 130) auf der Oberseite der zweiten optischen Komponente (2, 102) durch Unterdrucksetzung verwirklicht wird, vorzugsweise mit Hilfe eines polymeren Klebemittels.

**Claims**

**1.** A wavelength tunable laser emission device (1), comprising:

a first waveguide (31, 131) comprising an optical amplification means for producing a stimulated light emission, the first waveguide extending in a longitudinal direction of the emission device, a second waveguide (5, 105) made of silicon on silicon dioxide and disposed parallel to the first waveguide spaced from the first waveguide in a vertical direction of the emission device so as to allow the existence of a hybrid optical mode coupled at one and the same time to the second waveguide and to the first waveguide, the second waveguide comprising a distributed reflector (9, 109) along the second waveguide square with the first waveguide, the second waveguide comprising transverse zones (11, 12, 13, 14; 111, 112, 113, 114, 46, 47, 48) doped differently so as to form a polar junction oriented in a transverse direction of the emission device, first electrodes (35, 36; 135, 136) coupled to the first waveguide for injecting a pumping current into the optical amplification means, and second electrodes (15, 16; 115, 116) coupled to the doped transverse zones of the second waveguide so as to modify an effective index of the second waveguide seen by the hybrid optical mode.

**2.** The device as claimed in claim 1, in which the first waveguide (31, 32, 33) is made of an active material from group III-V.

**3.** The device as claimed in claim 1 or 2, in which a silicon dioxide layer (8, 108) of small thickness is disposed between the second waveguide and the first waveguide, the silicon dioxide layer (8, 108) of small thickness exhibiting a thickness of less than 100 nm.

**4.** The device as claimed in one of claims 1 to 3, in which the polar junction (11, 12, 13, 14) is of P-N type.

**5.** The device as claimed in one of claims 1 to 3, in which the polar junction (111, 112, 113, 114, 46, 47, 48) is of P-I-P-I-N type.

**6.** The device as claimed in one of claims 1 to 5, in which the polar junction comprises a first external transverse zone (11, 111) strongly doped positively and a second external transverse zone (14, 114) strongly doped negatively, the second electrodes being disposed respectively on the two strongly doped external transverse zones.

**7.** The device as claimed in one of claims 1 to 6, in which the distributed reflector (9, 109) exhibits a coupling coefficient of between 10 cm$^{-1}$ and 200 cm$^{-1}$.

**8.** The device as claimed in one of claims 1 to 7, in which the second waveguide (5, 105) made of silicon on silicon dioxide exhibits a thickness of between 400 nm and 600 nm.

**9.** The device as claimed in one of claims 1 to 8, in which the distributed reflector (9, 109) is periodic.

10. The device as claimed in one of claims 1 to 9, in which the second waveguide (5, 105) comprises two sampled gratings, each sampled grating comprising a plurality of periodic zones (209, 309) corresponding to a spatial sampling period ($\Lambda_1$, $\Lambda_2$), which is different in the two sampled gratings and, in each of the periodic zones (209, 309), the sampled grating being etched solely over a portion of the length of the sampling period ($\Lambda_1$, $\Lambda_2$), with a shorter spatial period ($\Lambda_b$) than the sampling period.

11. The device as claimed in one of claims 1 to 10, furthermore comprising an optical reflector element (23) arranged at a longitudinal end of the device.

12. The device as claimed in one of claims 1 to 11, in which the second waveguide comprises an extraction zone (37) for radiating the light of the hybrid optical mode out of the laser emission device.

13. An optical communication terminal (60) comprising:

a tunable laser emission device (64) as claimed in one of claims 1 to 11 for generating a monochromatic optical carrier signal,
an optical modulator for modulating a data signal on the carrier signal,
a temperature sensor (65), and
a wavelength stabilization module (66) coupled to the second electrodes of the laser emission device (64) to apply an electrical control signal in the second waveguide, the wavelength stabilization module being able to produce the control signal as a function of a measurement signal of the temperature sensor so as to compensate a thermal drift of the wavelength of the optical carrier signal.

14. A fabrication process for fabricating a wavelength tunable laser emission device, the process comprising:

making a second monolithic optical component (20, 102) comprising a second waveguide (5, 105) made of silicon on silicon dioxide and extending in a longitudinal direction of the second monolithic optical component, the second waveguide comprising a distributed reflector (9, 109) along the second waveguide, the second waveguide comprising transverse zones (11, 12, 13, 14; 111, 112, 113, 114, 46, 47, 48) doped differently so as to form a polar junction oriented in a transverse direction of the second optical component, the second monolithic optical component comprising a superficial layer (8, 108) of silicon dioxide of small thickness covering the second waveguide at an upper surface of the second optical component,
adhesively bonding a first monolithic optical component (30, 130) made of materials from group III-V on the upper surface (51) of the second optical component, the first monolithic optical component comprising a light-amplifying guiding layer (31, 131), making a first waveguide in the first monolithic optical component, the first waveguide being made in an aligned manner by lithography with the second waveguide,
forming on the first monolithic optical component first electrodes (35, 36; 135, 136) for controlling the optical amplification gain, and
forming on the second monolithic optical component second electrodes (15, 16; 115, 116) coupled to the doped transverse zones of the second waveguide so as to modify an effective index of the second waveguide.

15. The process as claimed in claim 14, in which the adhesive bonding of the first monolithic optical component (30, 130) on the upper surface of the second optical component (2, 102) is carried out by pressurization, preferably with the aid of a polymer adhesive.

FIG.1

FIG.2

FIG.3

EP 2 811 593 B1

**FIG.4A**

**FIG.4B**

**FIG.4C**

**FIG.5A**

**FIG.5B**

**FIG.5C**

FIG.6A

FIG.6B

FIG.6C

FIG.7A

FIG.7B

FIG.7C

EP 2 811 593 B1

EP 2 811 593 B1

108   51

FIG.8A

51   108

FIG.8B

114   51   107   108   102

N++   N+   PS   P+   P++

FIG.8C

131

109

104   105

FIG.9A

105

104

FIG.9B

130   133   131

114   108   132   111   102

N++   N+   PS   P+   P++

FIG.9C

FIG.10A

FIG.10B

FIG.10C

FIG.11

EP 2 811 593 B1

FIG.12

FIG.13